# EUROPEAN PATENT APPLICATION

(11) **EP 4 672 928 A1**
(43) Date of publication of application: **31.12.2025**
(21) Application number: 24910474.6
(22) Date of filing: 26.11.2024
(51) Int. Cl.: H10K 30/50

(54) **PEROVSKITE CELL MODULE INCLUDING STACKED ENCAPSULATION LAYER, AND PREPARATION METHOD THEREFOR**

(30) Priority: 29.12.2023 CN 202311853958
(71) Applicant: Xi'an TJ-Solar New Energy Co., Ltd, Xianyang, Shaanxi 712046 (CN)
(72) Inventor: LI, Peizhou, Xianyang, Shaanxi 712046 (CN); ZHAO, Changzheng, Xianyang, Shaanxi 712046 (CN)
(74) Representative: Berggren Oy
(86) International application number: PCT/CN2024/134638
(87) International publication number: WO 2025/139541

(57) **Abstract**

The present invention belongs to the technical field of perovskite solar cells, and relates to a perovskite cell module including a stacked encapsulation layer and a preparation method thereof. The perovskite cell module includes a stacked encapsulation layer, and the stacked encapsulation layer is formed by an inorganic encapsulation layer, or by an organic encapsulation layer and an inorganic encapsulation layer alternately stacked on top of each other. The inorganic encapsulation layer has excellent light transmittance and excellent moisture and/or oxygen barrier performance, while the organic encapsulation layer includes different components from the inorganic encapsulation layer and complements the performance characteristics of the inorganic encapsulation layer. Therefore, the perovskite cell module has good mechanical performance and can effectively protect a perovskite solar cell from the effects of oxygen and moisture, thereby improving the lifespan and stability of the cell. Moreover, the encapsulation method involved is simple and cost-effective, and can be used for large-scale production.

## Description

### Technical Field

The present invention belongs to the technical field of perovskite solar cells, and relates to a perovskite cell module including a stacked encapsulation layer and a preparation method thereof.

### Background

Solar energy, as a pure and renewable energy source, has unparalleled advantages over other energy sources. Since its inception, photovoltaic power generation has rapidly become one of effective technical means of utilizing solar energy. Perovskite solar cells are a type of photovoltaic power generation devices that have been rapidly emerging in recent years, with their efficiency rapidly increasing from 3.8% initially to 26.1% currently. Compared to other mature photovoltaic techniques, the perovskite solar cells have outstanding advantages of low cost, simple preparation, high photoelectric conversion efficiency, and commercial development potential.

Since a perovskite layer is reactive with moisture and oxygen, the performance of the perovskite solar cell is particularly susceptible to degradation, and the lifespan and application range of the perovskite solar cell are greatly reduced. Therefore, it is necessary to encapsulate the perovskite solar cell to improve the environmental stability of a module and block moisture and oxygen in the air. The existing solar cell encapsulation techniques are still unable to meet the requirements of practical applications, have the problems such as unreasonable encapsulation structures and poor mechanical performance after encapsulating, have not effectively improved the efficiency, stability, and lifespan of the module, and limit the application range thereof.

Based on the above, the present invention is proposed.

### Summary

An objective of the present invention is to overcome the drawbacks of the prior art and provides a perovskite cell module including a stacked encapsulation layer and a preparation method thereof, to improve the lifespan and stability of the cell.

To achieve the above objective, the present invention provides the following technical solutions:
The perovskite cell module including a stacked encapsulation layer includes a stacked encapsulation layer disposed on top of a functional layer of the perovskite cell module. The functional layer includes a substrate, a second electrode layer, a hole transport layer, a perovskite layer, an electron transport layer, and a first electrode layer.

The stacked encapsulation layer includes an inorganic encapsulation layer; or, the stacked encapsulation layer includes a structure in which an organic encapsulation layer and an inorganic encapsulation layer are alternately stacked on top of each other.

The substrate is transparent glass or transparent plastic such as PET.

The functional layer includes the substrate, the second electrode layer, the hole transport layer, the perovskite layer, the electron transport layer, and the first electrode layer stacked in sequence from bottom to top; or, the functional layer includes the substrate, the second electrode layer, the electron transport layer, the perovskite layer, the hole transport layer, and the first electrode layer stacked in sequence from bottom to top.

The hole transport layer is a layered structure prepared from nickel oxide, doped nickel oxide, cuprous iodide, cuprous thiocyanate, poly[bis(4-phenyl)(2,4,6-trimethylphenyl)amine] (PTAA), PEDOT: PSS, or Spiro-OMeTAD, and the thickness of the hole transport layer is 10 nm to 100 nm.

The electron transport layer is a layered structure prepared from any one or a mixture of titanium dioxide (TiO₂), tin oxide (SnO₂), indium oxide (InO₃), zinc oxide (ZnO), PCBM, and C₆₀, and the thickness of the electron transport layer is 10 nm to 100 nm.

The material of the second electrode layer is one or more of gold (Au), silver (Ag), copper (Cu), and aluminum (Al), the thickness of the second electrode layer is 10 nm to 200 nm, and the second electrode layer can be deposited onto the substrate by an evaporation deposition or PVD process.

The material of the first electrode layer is one or more of fluorine-doped tin oxide (FTO), indium tin oxide (ITO), aluminum zinc oxide (AZO), gallium zinc oxide (GZO), indium zinc oxide (IZO), and tungsten-doped indium oxide (IWO), the thickness of the first electrode layer is 10 nm to 200 nm, and the first electrode layer can be deposited onto the electron transport layer or the hole transport layer by magnetron sputtering.

Further preferably, the stacked encapsulation layer is a multi-layer structure in which an organic encapsulation layer and an inorganic encapsulation layer are alternately stacked on top of each other, and the outermost layer of the stacked encapsulation layer can be an inorganic encapsulation layer.

Specifically, the thickness of the organic encapsulation layer is in a range of 50 nm to 50 µm; and the thickness of the inorganic encapsulation layer is in a range of 5 nm to 1,000 nm.

The organic encapsulation layer is a polymer thin film formed by coating an ink composition onto a substrate by inkjet printing, spraying, roller coating, scrape coating, or spin coating, and curing through heating or UV exposure.

Further, the ink composition includes a photocurable monomer and a photopolymerization initiator, and the photocurable monomer is any one or a mixture of a methacrylate compound, an acrylate compound, an epoxy compound, a vinyl compound, and a vinyl ether compound.

Further, the inorganic encapsulation layer can be prepared by any one or a combination of chemical vapor deposition (CVD), plasma-enhanced chemical vapor deposition (PECVD), sputtering, sublimation, electron cyclotron resonance plasma-enhanced chemical vapor deposition (ECR-PECVD).

Further, the inorganic encapsulation layer can include a metal or non-metal, a metal oxide or non-metal oxide, a metal nitride or non-metal nitride, a metal carbide or non-metal carbide, a metal oxynitride or non-metal oxynitride, and a metal silicide or non-metal silicide, or a mixture thereof.

Specifically, the inorganic encapsulation layer can include silicon (Si), tin (Sn), stibium (Sb), aluminum (Al), zinc (Zn), stibium (Sb), bismuth (Bi), indium (In), selenium (Se), germanium (Ge), a transition metal, and a lanthanide metal, but is not limited thereto.

Preferably, the stacked encapsulation layer is a three-layer structure in which a first inorganic encapsulation layer, an organic encapsulation layer, and a second inorganic encapsulation layer are alternately stacked on top of each other. The first inorganic encapsulation layer and the second inorganic encapsulation layer can each include a silicon nitride (SiNx), a silicon oxide (SiOx), a silicon oxynitride (SiOxNy), ZnO, ZnSe, Sb₂O₃, and AlOx, including Al₂O₃, In₂O₃, or SnO₂, wherein x and y are both in a range of 1 to 5.

It should be emphasized that the stacked encapsulation layer is formed by the organic encapsulation layer and the inorganic encapsulation layer, and the organic encapsulation layer can planarize the inorganic encapsulation layer and prevent defects in the inorganic encapsulation layer, thereby preventing the penetration of external moisture and oxygen, and forming the stacked encapsulation layer.

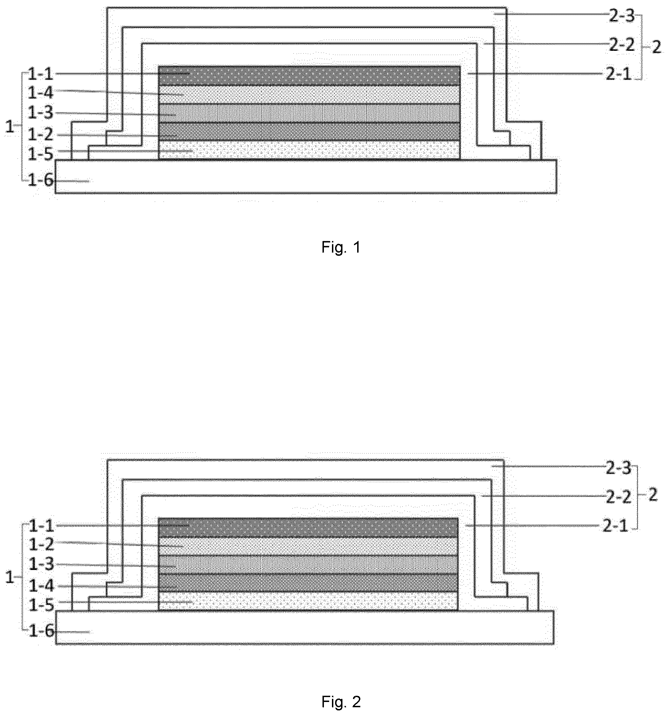

As shown in Fig. 1, in the stacked encapsulation layer, a first inorganic encapsulation layer, a first organic encapsulation layer, and a second inorganic encapsulation layer are alternately stacked on top of each other. In other implementations, the stacked encapsulation layer can be a structure of a single inorganic encapsulation layer, or the stacked encapsulation layer can be a total of 5 to 7 layers. In a structure in which the stacked encapsulation layer includes a total of 5 layers, the stacked encapsulation layer can include a first inorganic encapsulation layer, a first organic encapsulation layer, a second inorganic encapsulation layer, a second organic encapsulation layer, and a third inorganic encapsulation layer stacked in sequence. The inorganic encapsulation layer or organic encapsulation layer of the stacked encapsulation layer is directly formed on a perovskite cell to encapsulate the perovskite cell.

In addition, the present invention further provides a method for preparing a perovskite cell module including a stacked encapsulation layer, including the following steps:
S1: pretreating a substrate;
S2: preparing a second electrode layer, a hole transport layer, a perovskite layer, an electron transport layer, and a first electrode layer in sequence on the pretreated substrate;
S3: preparing an inorganic encapsulation layer on top of the first electrode layer by any one or a combination of chemical vapor deposition, plasma-enhanced chemical vapor deposition (e.g., electron cyclotron resonance plasma-enhanced chemical vapor deposition), sputtering, or sublimation;
S4: coating an organic encapsulation layer onto the inorganic encapsulation layer by inkjet printing, spraying, roller coating, scrape coating, or spin coating, and forming a polymer thin film, i.e., the organic encapsulation layer, by curing through heating or UV exposure;
S5: carrying out deposition and coating on a surface to be encapsulated in an alternating form of an inorganic encapsulation layer, an organic encapsulation layer, and an inorganic encapsulation layer, the inorganic encapsulation layer, organic encapsulation layer, and inorganic encapsulation layer deposited and coated on the surface of an object to be encapsulated being the stacked encapsulation layer.

It should be noted that the thickness of the organic encapsulation layer can be adaptively set according to actual encapsulation requirements, optionally 50 nm, 300 nm, 300 nm, 400 nm, 600 nm, 700 nm, 800 nm, 900 nm, 1,000 nm, 5 µm, 10 µm, 20 µm, 30 µm, 40 µm, or 50 µm. The thickness of the inorganic encapsulation layer can also be adaptively set according to actual encapsulation requirements, optionally 5 nm, 10 nm, 20 nm, 30 nm, 40 nm, 50 nm, 60 nm, 70 nm, 80 nm, 90 nm, 100 nm, 200 nm, 300 nm, 400 nm, 500 nm, 600 nm, 700 nm, 800 nm, 900 nm, or 1,000 nm.

Compared with the prior art, the technical solutions provided by the present invention includes the following beneficial effects:
The stacked encapsulation layer for encapsulating a perovskite cell provided by the present invention can be formed by an inorganic encapsulation layer, or by an organic encapsulation layer and an inorganic encapsulation layer alternately stacked on top of each other. The inorganic encapsulation layer exhibits excellent light transmittance and excellent moisture and/or oxygen barrier performance, while the organic layer includes different components from the inorganic layer and complementing the performance characteristics of the inorganic layer. The encapsulation structure has good mechanical performance and can effectively protect a perovskite solar cell from the effects of oxygen and moisture, thereby improving the lifespan and stability of the cell. Moreover, the encapsulation method involved is simple and cost-effective, and can be used for large-scale production.

### Brief Description of the Drawings

The accompanying drawings, which are incorporated in and constitute a part of this specification, together with the specification, serve to explain the principles of the present invention.

In order to more clearly illustrate the technical solutions in the embodiments of the present invention, the accompanying drawings required for descriptions in the embodiments will be briefly introduced below. Apparently, those skilled in the art can also obtain other accompanying drawings from these accompanying drawings without creative efforts.
Fig. 1 is a cross-sectional view of a perovskite cell module including a stacked encapsulation layer provided in Embodiment 1 of the present invention; and
Fig. 2 is a cross-sectional view of a perovskite cell module including a stacked encapsulation layer provided in Embodiment 5 of the present invention.

In the figures: 1, Perovskite solar cell; 1-1, First electrode layer; 1-2, Hole transport layer; 1-3, Perovskite layer; 1-4, Electron transport layer; 1-5, Second electrode layer; 1-6, Substrate; 2, Stacked encapsulation layer; 2-1, First inorganic encapsulation layer; 2-2, First organic encapsulation layer; 2-3, Second inorganic encapsulation layer.

### Detailed Description of the Embodiments

Exemplary embodiments are described in detail herein, and examples of the exemplary embodiments are shown in the drawings. When the following descriptions involve the drawings, unless otherwise indicated, the same numerals in different drawings represent the same or similar elements. The implementations set forth in the following descriptions of exemplary embodiments do not represent all implementations consistent with the present invention. On the contrary, they are merely examples consistent with some aspects of the present invention as described in the appended claims.

In order to make those skilled in the art to better understand the technical solutions of the present invention, the present invention will be further described in detail below with reference to the drawings and embodiments.

### Embodiment 1

This embodiment provides a perovskite cell module including a stacked encapsulation layer, and the perovskite cell module includes a substrate 1-6, a second electrode layer 1-5, a hole transport layer 1-2, a perovskite layer 1-3, an electron transport layer 1-4, a first electrode layer 1-1, and a stacked encapsulation layer 2 in sequence from bottom to top. As shown in Fig. 1, the stacked encapsulation layer 2 includes a first inorganic encapsulation layer 2-1, a first organic encapsulation layer 2-2, and a second inorganic encapsulation layer 2-3 stacked in sequence on top of the first electrode layer .

Further, both the first inorganic encapsulation layer 2-1 and the second inorganic encapsulation layer 2-3 can include an inorganic material having excellent light transmittance. The first inorganic encapsulation layer 2-1 and the second inorganic encapsulation layer 2-3 can be formed from the same or different inorganic materials. The inorganic encapsulation layer in this embodiment can be a silicon nitride (SiNx), wherein x is in a range of 1 to 5.

Optionally, the first inorganic encapsulation layer 2-1 and the second inorganic encapsulation layer 2-3 can also be any one or a mixture of SiNx, SiOx, SiOxNy, ZnO, ZnSe, Sb₂O₃, and AlOx, wherein x and y are both in a range of 1 to 5.

Further, the substrate is a transparent conductive ITO substrate. The second electrode layer 1-5 is Ag. The hole transport layer 1-2 is nickel oxide. The electron transport layer 1-4 is TiO₂. The first electrode layer 1-1 is ITO, and can be deposited onto the electron transport layer 1-4 by magnetron sputtering.

Further, the organic encapsulation layer is a polymer thin film formed by coating an ink composition onto the substrate by inkjet printing, spraying, roller coating, scrape coating, or spin coating, and curing through heating or UV exposure. The ink composition includes a photocurable monomer and a photopolymerization initiator. The photocurable monomer is a methacrylate compound, specifically a mixture of dicyclopentenyl ethoxymethacrylate, 2-phenoxyethyl acrylate, and trimethylolpropane triacrylate. The photopolymerization initiator can be TPO.

Optionally, the photocurable monomer can also be any one or a mixture of an acrylate compound, an epoxy compound, a vinyl compound, and a vinyl ether compound.

A method for preparing the perovskite cell module including a stacked encapsulation layer mentioned above includes the following steps:
S1: pretreating a substrate 1-6;
S2: sequentially preparing a second electrode layer 1-5, a hole transport layer 1-2, a perovskite layer 1-3, an electron transport layer 1-4, and a first electrode layer 1-1 in sequence on the pretreated substrate 1-6;
S3: preparing a first inorganic encapsulation layer 2-1 on top of the first electrode layer 1-1 by chemical vapor deposition;
S4: coating a first organic encapsulation layer 2-2 onto the first inorganic encapsulation layer 2-1 by spin coating, and forming a polymer thin film, i.e., the first organic encapsulation layer 2-2, by curing through UV exposure; and
S5: preparing a second inorganic encapsulation layer 2-3 on top of the first organic encapsulation layer 2-2 by chemical vapor deposition.

Optionally, the inorganic encapsulation layer is prepared by any one or a combination of chemical vapor deposition, plasma-enhanced chemical vapor deposition, sputtering, or sublimation.

Further, the thickness of the first inorganic encapsulation layer 2-1 is 50nm, the thickness of the first organic encapsulation layer 2-2 is 20µm, and the thickness of the second inorganic encapsulation layer 2-3 is 70nm.

### Embodiment 2

Based on Embodiment 1, the difference of Embodiment 2 from Embodiment 1 is that a stacked encapsulation layer 2 is a single inorganic encapsulation layer with a thickness of 400nm.

### Embodiment 3

Based on Embodiment 1, the difference of Embodiment 3 from Embodiment 1 is that a stacked encapsulation layer 2 is a 5-layer structure, namely a first inorganic encapsulation layer 2-1, a first organic encapsulation layer 2-2, a second inorganic encapsulation layer 2-3, a second organic encapsulation layer, and a third inorganic encapsulation layer. The thickness of the first inorganic encapsulation layer 2-1, the thickness of the second inorganic encapsulation layer 2-3, and the thickness of the third inorganic encapsulation layer are 60 nm, 80 nm, and 100 nm, respectively. The thickness of the first organic encapsulation layer 2-2 and the thickness of the second organic encapsulation layer are 10 µm and 15 µm, respectively.

### Embodiment 4

Based on Embodiment 1, the difference of Embodiment 4 from Embodiment 1 is that a stacked encapsulation layer 2 is a 7-layer structure, namely a first inorganic encapsulation layer 2-1, a first organic encapsulation layer 2-2, a second inorganic encapsulation layer 2-3, a second organic encapsulation layer, a third inorganic encapsulation layer, a third organic encapsulation layer, and a fourth inorganic encapsulation layer. The thickness of the first inorganic encapsulation layer 2-1, the thickness of the second inorganic encapsulation layer 2-3, the thickness of the third inorganic encapsulation layer, and the thickness of the fourth inorganic encapsulation layer are 10 nm, 20 nm, 90 nm, and 200 nm, respectively. The thickness of the first organic encapsulation layer 2-2, the thickness of the second organic encapsulation layer, and the thickness of the third organic encapsulation layer are 7 µm, 12 µm, and 20 µm, respectively.

### Embodiment 5

Based on Embodiment 1, the difference of Embodiment 5 from Embodiment 1 is that, a perovskite cell module including a stacked encapsulation layer includes a substrate 1-6, a second electrode layer 1-5, an electron transport layer 1-4, a perovskite layer 1-3, a hole transport layer 1-2, a first electrode layer 1-1, and a stacked encapsulation layer 2 in sequence from bottom to top, as shown in Fig. 2.

The stacked encapsulation layer 2 includes a first inorganic encapsulation layer 2-1, a first organic encapsulation layer 2-2, and a second inorganic encapsulation layer 2-3 stacked in sequence on top of the first electrode layer 1-1. The thickness of the first inorganic encapsulation layer 2-1 is 50 nm, the thickness of the first organic encapsulation layer 2-2 is 30 µm, and the thickness of the second inorganic encapsulation layer 2-3 is 40 nm.

### Comparative Example

An existing Chinese patent document (publication number: CN115084386A, publication date: September 20, 2022) discloses an encapsulation structure of perovskite solar cell , including a first encapsulation substrate, a perovskite solar cell, and a second encapsulation substrate in sequence from bottom to top, and further including a pressure component. The pressure component includes a shell and an elastic component disposed in the shell, the perovskite solar cell is nested in a cavity of the shell, the elastic component is disposed between the perovskite solar cell and the second encapsulation substrate, and the elastic component is disposed along the circumference of the edge of the perovskite solar cell, which is obviously different from the encapsulation structure disclosed in the present invention.

To verify the effectiveness of the technical solutions provided by the present invention, standard performance tests were conducted on the perovskite cell modules disclosed in Embodiments 1 to 5, by a specific testing method as follows:
(1) Test of change in photoelectric conversion efficiency

Under one standard sun illumination, the photoelectric conversion efficiency of perovskite cells in 5 Embodiments was tracked and tested, and compared with the photoelectric conversion efficiency of a perovskite cell in the Comparative Example at the same time points. The results are shown in the table below:

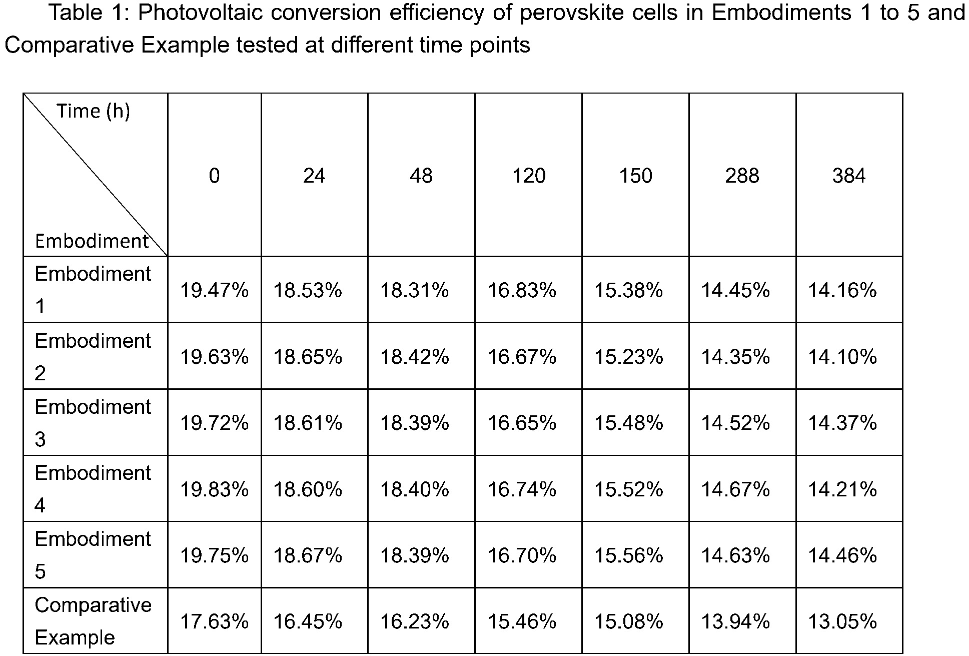

It should be noted that the average test value of 10 cells was obtained in each test of the embodiments and comparative example. From the above test results, compared with the comparative example, the encapsulation structure proposed by the present invention can effectively maintain the photoelectric conversion efficiency of the solar cells, and also has better oxygen isolation and waterproof performance, thereby improving the lifespan and stability of the cells.

The above descriptions are only specific implementations of the present invention to ensure that those skilled in the art can understand or implement the present invention. Various modifications to these embodiments are apparent to those skilled in the art, and the general principles defined herein can be implemented in other embodiments without departing from the spirit or scope of the present invention.

It will be appreciated that the present invention is not limited to the contents that have been described above, and that various modifications and changes can be made without departing from the scope thereof. It is intended that the scope of the present invention only be limited by the appended claims.

## Claims

1. A perovskite cell module comprising a stacked encapsulation layer, wherein the perovskite cell module comprises a stacked encapsulation layer (2) disposed on top of a functional layer of the perovskite cell module,
the stacked encapsulation layer (2) comprises an inorganic encapsulation layer, or, the stacked encapsulation layer (2) comprises a structure in which an organic encapsulation layer and an inorganic encapsulation layer are alternately stacked on top of each other.

2. The perovskite cell module comprising a stacked encapsulation layer according to claim 1, wherein a thickness of the organic encapsulation layer is in a range of 50 nm to 50 µm; and a thickness of the inorganic encapsulation layer is in a range of 5 nm to 1,000 nm.

3. The perovskite cell module comprising a stacked encapsulation layer according to claim 1, wherein a material of the organic encapsulation layer comprises any one or a mixture of a methacrylate compound, an acrylate compound, an epoxy compound, a vinyl compound, and a vinyl ether compound.

4. The perovskite cell module comprising a stacked encapsulation layer according to claim 1, wherein the organic encapsulation layer is a polymer thin film formed by coating an ink composition onto a substrate by inkjet printing, spraying, roller coating, scrape coating, or spin coating, and curing through heating or UV exposure.

5. The perovskite cell module comprising a stacked encapsulation layer according to claim 1, wherein the inorganic encapsulation layer comprises any one or a mixture of a metal or non-metal, a metal oxide or non-metal oxide, a metal nitride or non-metal nitride, a metal carbide or non-metal carbide, a metal oxynitride or non-metal oxynitride, and a metal silicide or non-metal silicide.

6. The perovskite cell module comprising a stacked encapsulation layer according to claim 5, wherein the inorganic encapsulation layer comprises any one or a mixture of SiNx, SiOx, SiOxNy, ZnO, ZnSe, Sb₂O₃, and AlOx, x and y being both in a range of 1 to 5.

7. The perovskite cell module comprising a stacked encapsulation layer according to claim 1, wherein the inorganic encapsulation layer is prepared by any one or a combination of chemical vapor deposition, plasma-enhanced chemical vapor deposition, sputtering, or sublimation.

8. The perovskite cell module comprising a stacked encapsulation layer according to claim 1, wherein a material of a first electrode layer (1-1) in the functional layer is one or more of fluorine-doped tin oxide, indium tin oxide, aluminum zinc oxide, gallium zinc oxide, indium zinc oxide, and tungsten-doped indium oxide; and a material of a second electrode layer (1-5) in the functional layer is one or more of gold, silver, copper, and aluminum.

9. The perovskite cell module comprising a stacked encapsulation layer according to claim 1, wherein a hole transport layer (1-2) in the functional layer is any one or a mixture of nickel oxide, doped nickel oxide, cuprous iodide, cuprous thiocyanate, PTAA, PEDOT: PSS, or Spiro-OMeTAD.

10. The perovskite cell module comprising a stacked encapsulation layer according to claim 1, wherein an electron transport layer (1-4) in the functional layer is any one or a mixture of TiO₂, SnO₂, InO₃, ZnO, PCBM, and C₆₀.
